# EUROPÄISCHE PATENTSCHRIFT

(11) **EP 0 825 716 B1**
(45) Veröffentlichungstag und Bekanntmachung des Hinweises auf die Patenterteilung: **21.01.2004**
(21) Anmeldenummer: 97113579.3
(22) Anmeldetag: 05.08.1997
(51) Int. Cl.: H03K 17/082

(54) **Ansteuerschaltung für ein Feldeffekt gesteuertes Halbleiterbauelement**
Drive circuit for a field-effect controlled semiconductor device
Circuit d'attaque pour un dispositif semi-conducteur commandé par effet de champ

(30) Priorität: 19.08.1996 DE 19633367
(43) Veröffentlichungstag der Anmeldung: 25.02.1998
(73) Patentinhaber: Infineon Technologies AG, 81669 München (DE)
(72) Erfinder: Strauss, Silvester, 9536 St. Egyden (AT); Zitta, Heinz, 9580 Droballach (AT)
(74) Vertreter: Bickel, Michael

(56) Entgegenhaltungen:
- EP-A- 0 762 652
- DE-A- 3 936 544
- DE-C- 4 429 716
- JP-A- 5 328 746
- US-A- 5 173 848

## Beschreibung

Die Erfindung betrifft eine Schaltungsanordnung zum Ansteuern eines einen Laststrom I_{L} führenden, durch Feldeffekt steuerbaren Halbleiterbauelementes mit einer ersten Quellenschaltung, die mit dem Steuereingang des Feldeffekt gesteuerten Halbleiterbauelementes verbunden ist, und mit einem steuerbaren Widerstand, der zu dem Steuereingang des Feldeffekt gesteuerten Halbleiterbauelementes parallel geschaltet ist und mit Mitteln steuerbar ist, die einen Teil des Laststroms I_{L}, der dem Laststrom I_{L} proportional ist, erfassen.

Eine solche Schaltungsanordnung ist allgemein bekannt und z. B. in der deutschen Patentschrift DE 44 29 716 C1 beschrieben worden.

Die Gateansteuerung des Halbleiterbauelementes erfolgt hier über einen Stromspiegel. Der steuerbare Widerstand ist ein Transistor. Überschreitet der am Sourceanschluß des Halbleiterbauelementes gemessene Laststrom I_{L} einen festgelegten Wert, wird der Transistor eingeschaltet und damit die Gatespannung des Halbleiterbauelementes reduziert. Der Laststrom I_{L} wird dadurch begrenzt.

Nachteil dieser Schaltungsanordnung ist, daß sich bei geschaltetem Transistor die Stromaufnahme der Ansteuerschaltung über den Eingangsanschluß erhöht.

Wird, um dies zu verhindern, der das Gate entladende Strom durch einen Widerstand begrenzt, so vergrößert sich die Schaltzeit des Halbleiterbauelementes.

Der Erfindung liegt die Aufgabe zugrunde, eine Schaltungsanordnung der beschriebenen Art so weiterzubilden, daß kurze Schaltzeiten erreicht werden und gleichzeitig bei ansprechender Strombegrenzung die Stromaufnahme der Ansteuerschaltung nicht ansteigt.

Erfindungsgemäß wird diese Aufgabe dadurch gelöst, daß zur ersten Quellenschaltung über einen Schalter eine zur ersten Quellenschaltung unabhängige zweite Quellenschaltung hinzuschaltbar ist, wobei der Schalter ebenfalls von den Mitteln derart ansteuerbar ist, daß er beim Überschreiten eines vorgegebenen Stroms öffnet.

Weiterbildungen der Erfindung sind Gegenstand der Unteransprüche.

Die erfindungsgemäße Ansteuerschaltung wird schaltungs-technisch besonders einfach, wenn als Quellenschaltungen Stromquellenschaltungen verwendet werden, die bei geschlossenem Schalter parallel geschaltet sind und sich die Ströme der Stromquellenschaltungen somit addieren.
Um die Funktionssicherheit der Ansteuerschaltung zu erhöhen, wird der Schalter nicht direkt, sondern über einen Inverter angesteuert. Der Inverter wandelt das analoge Schaltsignal für den Schalter in ein.Signal mit nahezu nur zwei möglichen Zuständen (High und Low). Der Schalter, der vorteilhaft als MOSFET ausgebildet wird, sperrt somit vollkommen oder schaltet ganz durch.
Der Inverter ist in CMOS-Technik aufgebaut und besitzt daher eine geringe Leistungsaufnahme.
Da die Stromversorgung der Ansteuerschaltung ausschließlich über ihren Eingangsanschluß erfolgt, muß keine externe Betriebsspannung zur Verfügung gestellt werden.
Da die Stromspiegel zur Bereitstellung des Stroms für den Inverter und die der Stromquellenschaltungen zu einer Strombank zusammengefaßt sind, können Transistoren eingespart werden. Mit Ausnahme der zwei Bipolartransistoren sind alle Transistoren MOSFETs, so daß die Ansteuerschaltung vorzugsweise in integrierter Technik hergestellt wird.

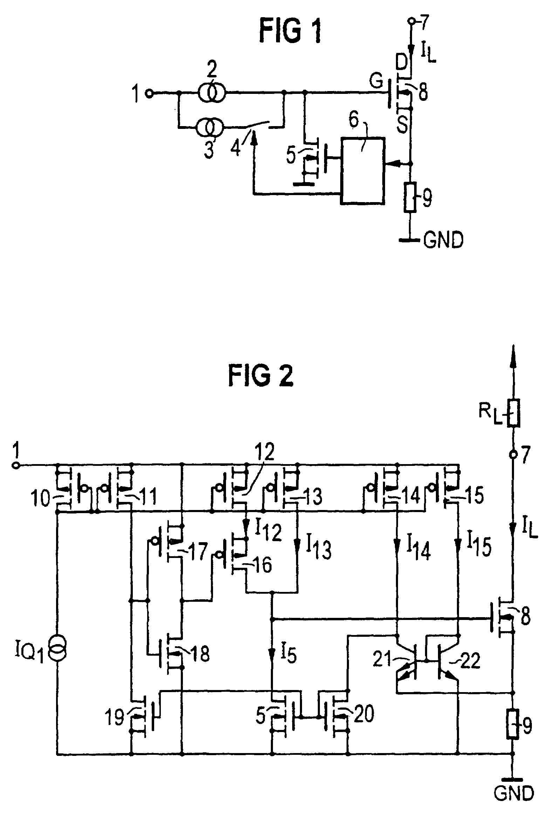

Die Erfindung wird anhand eines Ausführungsbeispiels in Verbindung mit den Figuren 1 und 2 näher erläutert.

Es zeigen:
- Figur 1: ein Prinzipschaltbild der Erfindung und
- Figur 2: ein Ausführungsbeispiel.

Die Schaltungsanordnung nach Figur 1 enthält ein Feldeffekt gesteuertes Halbleiterbauelement 8, das hier ein Leistungs-MOSFET ist. Sein Drainanschluß ist mit D, sein Sourceanschluß mit S und sein Gateanschluß mit G bezeichnet. Durch den Leistungs-MOSFET fließt ein Laststrom I_{L}. Zwischen dem Sourceanschluß und Masse (GND) liegt ein Meßwiderstand .9. Der Sourceanschluß ist mit Mitteln 6 verbunden, die einen Teil des Laststroms I_{L}, der dem Laststrom I_{L} proportional ist, erfassen.

Zwischen dem Gateanschluß und dem Eingangsanschluß 1 der Schaltungsanordnung liegt eine Parallelschaltung aus einer Stromquellenschaltung 2 und einer mit einem Schalter 4 in Serie geschalteten Stromquellenschaltung 3. Die Stromquellenschaltung 2 ist unabhängig von der Stromquellenschaltung 3. Der Steuerkontakt des Schalters 4 ist mit einem ersten Ausgang der Mittel 6 verbunden. Zwischen dem Gateanschluß und Masse befindet sich ein steuerbarer Widerstand 5, dessen Steuereingang mit einem weiteren Ausgang der Mittel 6 verbunden ist.

Liegt der Laststrom I_{L} unterhalb einer Schwelle, die durch die Dimensionierung des Meßwiderstandes 9 und der Dimensionierung der Mittel 6 bestimmt wird, so ist der Schalter 4 geschlossen und der Transistor 5 sperrt. Es steht genügend Strom für eine kurze Schaltzeit des Leistungs-MOSFET 8 zur Verfügung. Beim Überschreiten dieser Schwelle wird der Schalter 4 durch die Mittel 6 geöffnet und der Transistor 5 durch die Mittel 6 eingeschaltet. Damit wird der Ladestrom zum Gateanschluß des Leistungs-MOSFET 8 reduziert. Der Eingangsstrom am Eingangsanschluß 1 wird dann nur noch durch die Quellenschaltung 2 bestimmt. Die Stromaufnahme der Ansteuerschaltung wird nicht erhöht.

Im Ausführungsbeispiel nach Figur 2 finden sich der Leistungs-MOSFET 8, der Meßwiderstand 9 und der Transistor 5 wieder. Die Stromquellenschaltung 2 besteht hier aus einem Stromspiegel aus Transistoren 10 und 13, die Stromquellenschaltung 3 besteht aus einem Stromspiegel aus Transistoren 10 und 12. Beide Stromspiegel spiegeln den Referenzstrom einer Stromquelle I_{Q1}, die sich zwischen Masse und dem Drainanschluß des Transistors 10 befindet.
Der Schalter 4 besteht hier aus einem MOSFET 16. Das Gate des MOSFET 16 liegt am Ausgang eines Inverters, der aus einem p-Kanal MOSFET 17 und einem n-Kanal MOSFET 18 besteht. Die Drainanschlüsse der FETs 17 und 18 sind miteinander verbunden und bilden den Ausgang des Inverters. FET 17 liegt mit seinem Sourceanschluß am Eingangsanschluß 1. Der Sourceanschluß von FET 18 liegt auf Masse. Die beiden zusammengeschalteten Gateanschlüsse der FETs 17 und 18 bilden den Eingang des Inverters. Der Eingang ist zum einen mit dem Drainanschluß des Transistors 11 verbunden, der mit dem Transistor 10 einen Stromspiegel bildet, zum anderen mit dem Drainanschluß eines Transistors 19. Der Sourceanschluß des Transistors 19 liegt auf Masse. Der Gateanschluß ist mit dem Gateanschluß des Transistors 5 verbunden. Die Sourceanschlüsse der Transistoren 10 bis 15 sind mit dem Eingangsanschluß 1 verbunden.

Beim Anlegen einer Spannung an den Eingangsanschluß 1 ist, solange der Laststrom I_{L} unterhalb der vorgegebenen Strombegrenzungsschwelle liegt, der MOSFET 16 leitend und der Transistor 5 sperrt. Damit steht über die Transistoren 12 und 13 genügend Strom am Gateanschluß des Leistungs-MOSFET 8 zur Verfügung, und er schaltet schnell.
Die Transistoren 14 und 15 liefern die betragsgleichen Ströme I14 und I15. Der npn-Transistor 21 hat eine größere Emitterfläche als der npn-Transistor 22. Damit der Kollektorstrom von Transistor 21 dem Betrage nach gleich dem Kollektorstrom des Transistors 22 ist, muß die Basis-Emitterspannung des npn-Transistors 21 kleiner als die des npn-Transistors 22 sein. Steigt der Laststrom I_{L} nun an, so wird der Spannungsabfall am Meßwiderstand 9 größer und die Basis-Emitterspannung an dem npn-Transistor 21 sinkt. Damit wird sein Kollektorstrom kleiner. Der Anteil des Stroms I14, der nicht über den npn-Transistor 21 fließt, wird über den Stromspiegel aus den Transistoren 5 und 20 verstärkt, und das Gate des Leistungs-MOSFET 8 wird entladen. Der Laststrom I_{L} wird begrenzt. Über den Transistor 5 würde nun auch ein größerer Strom I5 gegen Masse abfließen und somit den Eingangsstrom am Eingangsanschluß 1 erhöhen. Dies wird dadurch verhindert, daß der Transistor 19 durchschaltet, sobald Transistor 5 leitend wird. Der Eingang des Inverters geht auf Masse (Schaltzustand Low) und damit der Ausgang auf ein Potential, so daß der MOSFET 16 sperrt. Der Strom I12 trägt nun keinen Anteil mehr am Eingangsstrom am Eingangsanschluß 1.

## Patentansprüche

1. Schaltungsanordnung zum Ansteuern eines einen Laststrom I_{L} führenden, Feldeffekt gesteuerten Halbleiterbauelementes, insbesondere eines Feldeffekt gesteuerten Leistungs-Halbleiterbauelementes, mit einer ersten Quellenschaltung (2), die mit dem Steuereingang des Feldeffekt gesteuerten Halbleiterbauelementes verbunden ist und mit einem steuerbaren widerstand, der zu dem Steuereingang des Feldeffekt gesteuerten Halbleiterbauelementes parallel geschaltet ist und mit Mitteln (6) steuerbar ist, die einen Teil des Laststroms I_{L}, der dem Laststrom I_{L} proportional ist, erfassen,
**dadurch gekennzeichnet,**
**daß** zur ersten Quellenschaltung (2) über einen Schalter (4) eine zur ersten Quellenschaltung (2) unabhängige zweite Quellenschaltung. (3) hinzuschaltbar ist, wobei der Schalter (4) ebenfalls von den Mitteln (6) derart ansteuerbar ist, daß er beim Überschreiten eines vorgegebenen Stroms öffnet.

2. Schaltungsanordnung nach Anspruch 1,
**dadurch gekennzeichnet,**
**daß** als Quellenschaltungen Stromquellenschaltungen (2, 3) vorgesehen sind und daß die erste Stromquellenschaltung (2) und die zweite Stromquellenschaltung (3) im geschlossenen Zustand des Schalters (4) parallel geschaltet sind.

3. Schaltungsanordnung nach Anspruch 1 oder 2,
**dadurch gekennzeichnet,**
**daß** der Schalter (4) und die Mittel (6) die das Schaltsignal für die Ansteuerung des Schalters (4) liefern, aus einem Schalter, der im Ruhezustand geschlossen ist, am Ausgang eines Inverters bestehen.

4. Schaltungsanordnung nach den Ansprüchen 1 bis 3,
**dadurch gekennzeichnet,**
**daß** die Stromversorgung der Ansteuerschaltung ausschließlich über ihren Eingangsanschluß (1) erfolgt.

5. Schaltungsanordnung nach Anspruch 3,
**dadurch gekennzeichnet,**
**daß** der Eingang des Inverters über einen Stromspiegel bestehend aus Transistoren (10) und (11) am Eingangsanschluß (1) und über einen Transistor (19) an Masse liegt.

6. Schaltungsanordnung nach den Ansprüchen 3 oder 5,
**dadurch gekennzeichnet,**
**daß** der Inverter aus einem p-Kanal MOSFET und einem n-Kanal MOSFET, die gateseitig und drainseitig miteinander verbunden sind, besteht und die Gateseite den Eingang und die Drainseite den Ausgang des Inverters bilden.

7. Schaltungsanordnung nach den Ansprüchen 1 bis 6,
**dadurch gekennzeichnet,**
**daß** der Schalter (4) ein MOSFET ist.

8. Schaltungsanordnung nach den Ansprüchen 1 bis 7,
**dadurch gekennzeichnet,**
**daß** der Transistor (10) mit einem Transistor (12) einen Stromspiegel und mit einem Transistor (13) einen weiteren Stromspiegel bildet und die beiden Stromspiegel die Stromquellenschaltungen (2) und (3) bilden.

9. Schaltungsanordnung nach den Ansprüchen 1 bis 8,
**dadurch gekennzeichnet,**
**daß** die Stromquellenschaltungen (2) und (3) aus MOSFETs bestehen.

## Claims

1. Circuit arrangement for driving a field-effect-controlled semiconductor component which carries a load current I_{L}, in particular a field-effect-controlled power semiconductor component, having a first source circuit (2), which is connected to the control input of the field-effect-controlled semiconductor component, and having a controllable resistor, which is connected in parallel with the control input of the field-effect-controlled semiconductor component and can be controlled by means (6) which acquire part of the load current I_{L} which is proportional to the load current I_{L}, **characterized in that** a second source circuit (3), which is independent of the first source circuit (2), can be supplementarily connected to the first source circuit (2) via a switch (4), it being possible to drive the switch (4), likewise by the means (6), in such a way that it opens when a predetermined current is exceeded.

2. Circuit arrangement according to Claim 1, **characterized in that** current source circuits (2, 3) are provided as the source circuits, and **in that** the first current source circuit (2) and the second current source circuit (3) are connected in parallel in the closed state of the switch (4).

3. Circuit arrangement according to Claim 1 or 2, **characterized in that** the switch (4) and the means (6) which supply the switching signal for driving the switch (4) comprise a switch, which is closed in the quiescent state, at the output of an invertor.

4. Circuit arrangement according to Claims 1 to 3, **characterized in that** the drive circuit is supplied with current exclusively via its input terminal (1).

5. Circuit arrangement according to Claim 3, **characterized in that** the input of the invertor is connected to the input terminal (1) via a current mirror comprising transistors (10) and (11) and is connected to ground via a transistor (19).

6. Circuit arrangement according to Claims 3 or 5, **characterized in that** the invertor comprises a p-channel MOSFET and an n-channel MOSFET, which are connected to one another on the gate side and on the drain side, and the gate side forms the input and the drain side the output of the invertor.

7. Circuit arrangement according to Claims 1 to 6, **characterized in that** the switch (4) is a MOSFET.

8. Circuit arrangement according to Claims 1 to 7, **characterized in that** the transistor (10) forms one current mirror with a transistor (12) and forms a further current mirror with a transistor (13), and the two current mirrors form the current source circuits (2) and (3).

9. Circuit arrangement according to Claims 1 to 8, **characterized in that** the current source circuits (2) and (3) comprise MOSFETs.

## Revendications

1. Agencement de circuit pour exciter un composant à semi-conducteur qui conduit un courant de charge I_{L} et qui est commandé par effet de champ, en particulier un composant à semi-conducteur de puissance commandé par effet de champ, comportant un premier circuit source (2) relié à l'entrée de commande du semi-conducteur de puissance commandé par effet de champ, et une résistance réglable montée en parallèle à l'entrée de commande du semi-conducteur de puissance commandé par effet de champ, peut être commandée par des moyens (6) qui enregistrent une partie du courant de charge I_{L} proportionnelle au courant de charge I_{L},
**caractérisé en ce qu'**
un commutateur (4) peut en outre commuter au premier circuit source (2) un deuxième circuit source (3) indépendant du premier circuit source (2), le commutateur (4) pouvant également être excité par les moyens (6) de telle manière qu'il s'ouvre en cas de dépassement d'un courant prédéterminé.

2. Agencement de circuit selon la revendication 1,
**caractérisé en ce que**
comme circuits source on prévoit des circuits source de courant (2, 3), et le premier circuit source de courant (2) ainsi que le deuxième circuit source de courant (3) sont montés en parallèle lorsque le commutateur (4) est à l'état fermé.

3. Agencement de circuit selon la revendication 1 ou 2,
**caractérisé en ce que**
le commutateur (4) et les moyens (6) qui fournissent le signal de commutation pour exciter le commutateur (4) consistent, à la sortie d'un inverseur, en un commutateur fermé à l'état de repos.

4. Agencement de circuit selon les revendications 1 à 3,
**caractérisé en ce que**
l'alimentation en courant du circuit d'excitation est réalisée exclusivement par son raccordement d'entrée (1).

5. Agencement de circuit selon la revendication 3,
**caractérisé en ce que**
l'entrée de l'inverseur est reliée au raccordement d'entrée (1) au moyen d'un miroir de courant constitué de transistors (10) et (11) et à la masse au moyen d'un transistor (19).

6. Agencement de circuit selon les revendications 3 ou 5,
**caractérisé en ce que**
l'inverseur consiste en un MOSFET à p canaux et en un MOSFET à n canaux qui sont reliés l'un à l'autre du côté grille et du côté drain, et le côté grille forme l'entrée et le côté drain la sortie de l'inverseur.

7. Agencement de circuit selon les revendications 1 à 6,
**caractérisé en ce que**
le commutateur (4) est un MOSFET.

8. Agencement de circuit selon les revendications 1 à 7,
**caractérisé en ce que**
le transistor (10) conjointement avec un transistor (12) forme un miroir de courant et, conjointement avec un transistor (13), un autre miroir de courant et les deux miroirs de courant forment les circuits source de courant (2) et (3).

9. Agencement de circuit selon les revendications 1 à 8,
**caractérisé en ce que**
les circuits source de courant (2) et (3) consistent en des MOSFET.
